Europäisches Patentamt

European Patent Office

Office européen des brevets

(11) Numéro de publication : **0 687 021 A1**

# (12) DEMANDE DE BREVET EUROPEEN

(21) Numéro de dépôt : **95401278.7**

(22) Date de dépôt : **01.06.95**

(51) Int. Cl.$^6$ : **H01L 39/16**, H02H 9/02

(30) Priorité : **06.06.94 FR 9406887**

(43) Date de publication de la demande :
**13.12.95 Bulletin 95/50**

(84) Etats contractants désignés :
**CH DE ES FR GB IT LI NL SE**

(71) Demandeur : **ALCATEL ALSTHOM COMPAGNIE GENERALE D'ELECTRICITE
54, rue La Boétie
F-75382 Paris Cédex 08 (FR)**

(72) Inventeur : **Belouet, Christian
1, rue Gaston Levy
F-92330 Sceaux (FR)**
Inventeur : **Verhaege, Thierry
22, allée Georges Brassens
F-91160 Saulx les Chartreux (FR)**

(74) Mandataire : **Fournier, Michel
SOSPI
14-16, rue de la Baume
F-75008 Paris (FR)**

(54) **Limiteur de courant supraconducteur à haute température**

(57)   Limiteur de courant supraconducteur caractérisé en ce qu'il comprend un barreau ou tube en matériau supraconducteur à haute température du type composite constitué de verre et d'un oxyde supraconducteur à haute température, la proportion en volume du verre étant comprise entre 10 et 40 %, le barreau ou tube étant choisi pour respecter les inégalités suivantes :

$$\rho > 10^{-4} \ \Omega.m$$
$$j_c > 10^{+5} \ A/m^2$$
$$\rho.(5j_c)^2 < 10^{11} \ W/m3$$

inégalités dans lesquelles :

$\rho$ désigne la résistivité du matériau à l'état normal (non supraconducteur),

$j_c$ désigne la densité de courant critique,

$\rho.(5j_c)^2$ désigne la puissance volumique dissipée dans le barreau ou tube pendant la phase de transition, étant donné qu'on définit la densité critique comme celle qui produit un champ électrique de $10^{-4}$ V/m le long du barreau ou tube et qu'on admet que la limitation a lieu pour une densité de courant égale à 5 fois la densité critique.

La présente invention concerne un limiteur de courant utilisant un matériau à haute température critique.

L'apparition des matériaux supraconducteurs à haute température critique, supérieure en particulier à la température de l'azote liquide, a fait naître des espoirs de réaliser des limiteurs de courant économiques.

Malheureusement, à ce jour, il n'est pas possible techniquement de réaliser de tels matériaux autrement qu'en tubes massifs.

On a décrit des limiteurs supraconducteurs utilisant une voie inductive et comprenant un circuit magnétique sur une branche duquel est placé un enroulement parcouru par le courant à limiter et dont l'autre branche est entourée par un bobinage en matériau supraconducteur parcouru par un courant continu. En régime normal, le circuit magnétique est saturé par le courant du tube supraconducteur; en cas de défaut, l'amplitude du courant dans l'enroulement entraîne la désaturation du circuit magnétique et des tensions inductives dans l'enroulement viennent en limiter le courant.

Cette solution est limitée aux faibles puissances car au-delà, le volume du circuit magnétique et du bobinage primaire deviennent prohibitifs.

On a également proposé des systèmes proches du précédent, dans lesquels le bobinage supraconducteur n'est pas parcouru par un courant continu, mais, étant fermé sur lui-même, est assimilable au secondaire en court-circuit d'un transformateur. Il développe ainsi un courant proportionnel au courant du primaire, qui blinde le circuit magnétique; lorsque le courant secondaire atteint le courant critique, celui-ci transite à l'état résistif, ce qui élimine le blindage et produit au primaire une forte impédance de limitation de courant. Cette voie permet effectivement de simplifier le bobinage supraconducteur, en le réduisant à un ou plusieurs tubes massifs. Elle est cependant, comme la précédente, fortement pénalisée par la taille du circuit magnétique et du bobinage primaire nécessaire.

On connaît des limiteurs utilisant une voie dite résistive, dans laquelle le courant à limiter traverse une portion en matériau supraconducteur dont la résistance augmente brusquement lorsque la densité critique, due par exemple à un courant de court-circuit, est dépassée.

De tels limiteurs existent avec des matériaux supraconducteurs à basse température critique.

On a envisagé également d'utiliser la voie résitive, avec un matériau supraconducteur à haute température critique, et mettant en oeuvre par exemple un brin en matériau supraconducteur à haute température à gaine métallique, par exemple en argent; cette gaine est nécessaire pour permettre la fabrication d'un fil de grande longueur. Cette solution n'est pas possible aux grandes puissances car la gaine métallique compromet l'effet limiteur.

Un but de l'invention est de réaliser un limiteur utilisant la voie résistive et mettant en oeuvre un matériau supraconducteur à haute température, réalisé sous forme d'un barreau ou tube de longueur métrique.

L'invention a pour objet un limiteur de courant supraconducteur caractérisé en ce qu'il comprend un barreau ou tube en matériau supraconducteur à haute température du type composite constitué de verre et d'un oxyde supraconducteur à haute température, la proportion en volume du verre étant comprise entre 10 et 40 %, le barreau ou tube étant choisi pour respecter les inégalités suivantes:

$$\rho > 10^{-4} \ \Omega.m$$
$$j_c > 10^{+5} \ A/m^2$$
$$\rho.(5j_c)^2 < 10^{11} \ W/m^3$$

inégalités dans lesquelles:

$\rho$ désigne la résistivité du matériau à l'état normal (non supraconducteur),

$j_c$ désigne la densité de courant critique,

$\rho.(5j_c)^2$ désigne la puissance volumique dissipée dans le barreau ou tube pendant la phase de transition, étant donné qu'on définit la densité critique comme celle qui produit un champ électrique de $10^{-4}$ V/m le long du barreau ou tube et qu'on admet que la limitation a lieu pour une densité de courant égale à 5 fois la densité critique.

De préférence, l'oxyde supraconducteur est du type $Bi_2Sr_2Ca_2Cu_3O_y$, avec y voisin de 10.

Dans un mode particulier de réalisation, le limiteur comprend une enveloppe isolante cylindrique, le barreau ou tube étant disposé axialement dans l'enveloppe qui est remplie partiellement d'azote liquide.

L'invention sera bien comprise par la description donnée ci-après d'un exemple de réalisation de l'invention, en référence au dessin ci-annexé dans lequel:

- la figure unique représente en coupe axiale un limiteur supraconducteur à haute température réalisé conformément à l'invention.

C'est un des mérites des inventeurs d'avoir imaginé que pour construire, dans l'état actuel de la technique, un limiteur supraconducteur à haute température critique, il fallait employer un matériau ayant des propriétés supraconductrices réputées médiocres.

Un tel matériau supraconducteur a été décrit dans la demande de brevet français n° 91 00072 déposé le 4 janvier 1991.

Ce matériau est caractérisé par le fait qu'il est constitué de verre et d'oxyde de matériau supraconducteur à haute température critique tel que Bi2Sr2Ca2Cu30y (avec y voisin de 10), le verre étant tel que sa température de transition vitreuse soit inférieure à 750 K, la proportion en volume de verre étant comprise entre 10 et 40 %, ledit oxyde se trouvant dans le verre sous forme de cristallites présentant sensiblement la même orientation.

Ce matériau a des propriétés supraconductrices qualifiées de médiocres pour les raisons suivantes:

- sa densité de courant critique jc est faible pour la valeur référence du champ de $10^{-4}$ V/m, de l'ordre de $10^{+5}$ à $10^{+6}$ A/m$^2$,
- sa résistivité à l'état normal est très supérieure à celle des autres supraconducteurs,
- le coude de la courbe du champ électrique en fonction de la densité de courant qu'on observe à la valeur critique de la densité de courant est peu accentué.

Un tel matériau permet cependant de réaliser un limiteur, comme on va le démontrer sur un exemple.

L'exemple est celui d'un limiteur destiné à limiter le courant de défaut pour une ligne de tension nominale $V_n$ = 63 kV et de courant nominal $I_n$ = 1,25 kA, soit une puissance de 45MVA.

Le but de l'invention est d'avoir un limiteur sous la forme d'un barreau ou tube ayant une longueur de l'ordre du mètre, une puissance volumique dissipée raisonnable lors de la phase de transition, par exemple inférieure à $10^{11}$ W/m$^3$ en admettant que lors du courant de défaut, la densité de courant atteint 5 fois la valeur de la densité critique.

Selon l'invention, le matériau est choisi pour que:

- la résistivité du matériau supraconducteur ρ à l'état normal soit supérieure à $10^{-4}$ Ω.m, typiquement $10^{-3}$,
- la densité de courant critique jc soit supérieure ou égale à $5.10^5$ A/m$^2$,
- la puissance volumique P dissipée dans le barreau ou tube pendant la phase de transition soit inférieure à $10^{11}$ W/m$^3$;

A titre d'exemple, avec ρ = $5.10^{-3}$ Ω.m et $j_c$ = $10^6$ A/m$^2$, il vient:

$$V_n = \rho . j_n . l$$

où

I est la longueur du barreau,

Vn est la tension nominale, soit 36.000 V

ρ est la résistivité en régime de limitation

jn est la densité de courant à l'état normal, soit $j_n = 5.j_c = 5.10^6$

d'où:

l = $36.000/10^{-3}.5.10^6$ = 7,2 mètres

La section s du barreau supraconducteur est alors égale à $I_n/j_c$, soit $1250 / 10^6$ = 0,00125m$^2$ = 12,5 cm$^2$

Le volume v du barreau est égal à:

7,2 m x 0,00125 m$^2$ = 0,009 m$^3$, soit 9 litres.

Les pertes résistives pf en régime de fonctionnement sont de l'ordre de:

$p_f$ = E.j.v = $10^{-4}$. $10^6$. 9. $10^{-3}$ = 9 watts, ce qui est parfaitement acceptable vis-à-vis de la puissance transitée de 45 MVA.

La puissance volumique P dissipée dans le barreau pendant la phase de limitation du courant est égale à :

P = ρ. $(5j_c)^2$. = $10^{-3}$. $(5.10^6)^2$ = 2,5 .$10^{10}$ W/m$^3$

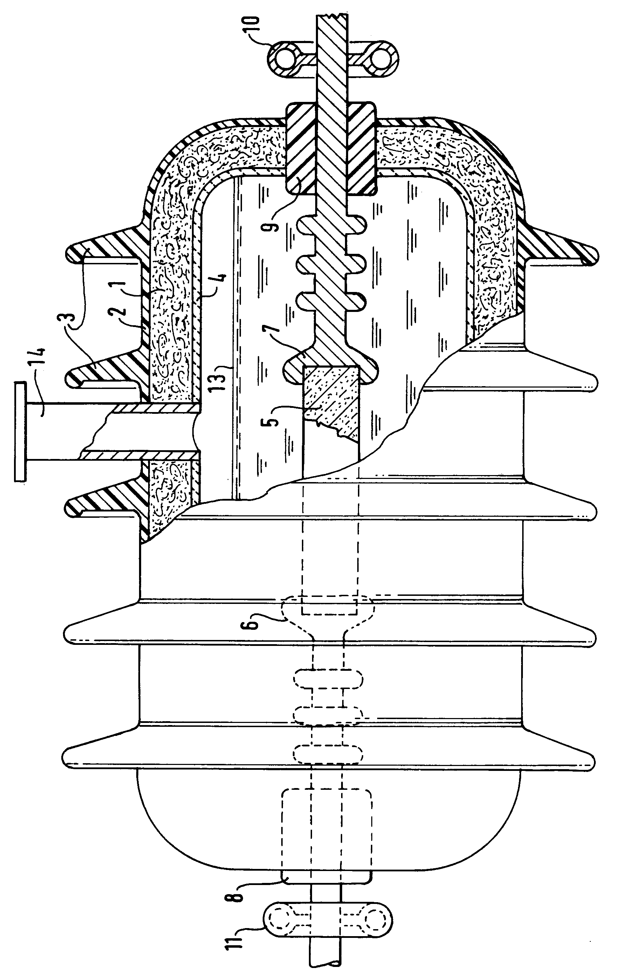

La figure 1 montre un schéma de réalisation du limiteur supraconducteur selon l'invention.

Il comprend une enceinte cylindrique en matériau isolant à la fois thermiquement et électriquement, par exemple constituée de mousse de polyuréthane 1 recouverte d'une couche en élastomère 2 munie d'ailettes 3; la rigidité peut être obtenue par une couche intérieure 4 en céramique.

Un barreau 5 en matériau supraconducteur à haute température critique est disposé dans l'axe de l'enceinte et maintenu par deux bras de cuivre 6 et 7 en série dans la ligne protégée.

L'étanchéité des traversées des bras 6 et 7 est assurée par des joints 8 et 9 en résine époxy chargée par exemple de billes de verre, ce qui évite la fissuration.

Des tores anti-corona 11, 12 assurent la répartition du potentiel au voisinage des traversées.

Le barreau est refroidi par un bain d'azote liquide 13 dont le transfert est assuré par une canalisation 14 à la partie supérieure de l'enveloppe.

Comme il a été dit plus haut, le matériau du barreau est un composite à base d'oxyde supraconducteur, constitué de verre et dudit oxyde, la proportion en volume de verre étant comprise entre 10 et 40%.

Le verre est avantageusement un verre comprenant un oxyde choisi parmi PbO, B2O3, Bi2O3, CaO, SiO2 et l'oxyde vitrifié correspondant à la formulation du supraconducteur.

Ledit oxyde supraconducteur est de préférence du type $Bi_2Sr_2Ca_2Cu_3O_y$, avec y voisin de 10.

En variante, toutes les compositions mentionnées au brevet cité ci-dessus peuvent être utilisées.

**Revendications**

1/ Limiteur de courant supraconducteur caractérisé en ce qu'il comprend un barreau ou tube en matériau supraconducteur à haute température du type composite constitué de verre et d'un oxyde supraconducteur à haute température, la proportion en volume du verre étant comprise entre 10 et 40 %, le barreau ou tube étant choisi pour respecter les inégalités suivantes:

$$\rho > 10^{-4} \ \Omega.m$$
$$j_c > 10^{+5} \ A/m^2$$
$$\rho.(5j_c)^2 < 10^{11} \ W/m^3$$

inégalités dans lesquelles:

ρ désigne la résistivité du matériau à l'état normal (non supraconducteur),

jc désigne la densité de courant critique,

ρ.$(5j_c)^2$ désigne la puissance volumique dissipée dans le barreau ou tube pendant la phase de transition,

étant donné qu'on définit la densité critique comme celle qui produit un champ électrique de

$10^{-4}$ V/m le long du barreau ou tube et qu'on admet que la limitation a lieu pour une densité de courant égale à 5 fois la densité critique.

**2/** Limiteur supraconducteur selon la revendication 1, caractérisé en ce que l'oxyde supraconducteur est du type $Bi_2Sr_2Ca_2Cu_3O_y$, avec y voisin de 10.

EP 0 687 021 A1

| Office européen des brevets | RAPPORT DE RECHERCHE EUROPEENNE | Numero de la demande EP 95 40 1278 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP,A,0 525 313 (HOECHST AG) 3 Février 1993 <br> * le document en entier * <br> --- | 1,2 | H01L39/16 <br> H02H9/02 |
| A | EP,A,0 523 374 (ABB PATENT GMBH ;HOECHST AG (DE)) 20 Janvier 1993 <br> * le document en entier * <br> ----- | 1,2 | |

| | | | DOMAINES TECHNIQUES RECHERCHES (Int.Cl.6) |
|---|---|---|---|
| | | | H01L <br> H02H |

Le présent rapport a été établi pour toutes les revendications

| Lieu de la recherche | Date d'achèvement de la recherche | Examinateur |
|---|---|---|
| LA HAYE | 13 Septembre 1995 | Pelsers, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................
& : membre de la même famille, document correspondant

EPO FORM 1503 03.82 (P04C02)

6